# EUROPEAN PATENT SPECIFICATION

(11) **EP 4 322 370 B1**
(45) Date of publication and mention of the grant of the patent: **02.09.2026**
(21) Application number: 23180362.8
(22) Date of filing: 20.06.2023
(51) Int. Cl.: H02J 7/00, G01R 31/389, G01R 31/385, G01R 31/387, H02J 7/47

(54) **DETERMINATION METHOD OF BATTERY**
BESTIMMUNGSVERFAHREN FÜR EINE BATTERIE
PROCÉDÉ DE DÉTERMINATION DE BATTERIE

(30) Priority: 11.07.2022 JP 2022111143
(43) Date of publication of application: 14.02.2024
(73) Proprietor: TOYOTA JIDOSHA KABUSHIKI KAISHA, Toyota-shi, Aichi-ken, 471 8571 (JP)
(72) Inventor: KOMIYAMA, Keita, Toyota-shi, 471-8571 (JP)
(74) Representative: J A Kemp LLP

(56) References cited:
- EP-A1- 3 863 103
- EP-B1- 2 461 172
- EP-B1- 2 571 077
- JP-A- 2015 195 096
- US-A1- 2007 192 877
- US-A1- 2019 033 937
- US-B2- 7 683 571

## Description

### Technical Field

The present disclosure relates to a determination method of a battery.

### Background Art

In relation to a battery, a technique of determining a battery produced by a regular manufacturer (hereinafter referred to as a genuine product), and batteries such as a battery imitating the genuine product and a battery that is illegally modified the genuine product (hereinafter referred to as a non-genuine product) have been known. For example, Patent Literature 1 discloses a battery pack comprising a controlling part determining a battery is not genuine when an absolute value of a difference in the weight of batteries is larger than a value arranged in advance. US10720079B1 provides disclosure relating to interactive driver development. US20170097243A1 discloses a driver facts behavior information storage system. JP2011063268A provides disclosure relating to on-vehicle electronic equipment and programs. US2007192877A1 provides disclosure relating to battery authentication in a wireless communication device. US7683571B2 discloses an electronic device, method for controlling the same, and program for the same. US2019033937A1 discloses an electronic apparatus and control method. EP2461172B1, JP2015195096A, EP2571077B1 and EP3863103A1 disclose further methods of battery authentication.

### Citation List

### Patent Literature

Patent Literature 1: Japanese Patent Application Laid-Open (JP-A) No. 2012-174487

### Summary of Disclosure

### Technical Problem

For example, in Patent Literature 1, determination of the non-genuine product is performed based on the difference in the weight of batteries, but it is desired to determine the non-genuine product even when there is no difference in the weight of batteries. The present disclosure has been made in view of the above circumstances, and a main object thereof is to provide a determination method of a battery capable of determining the non-genuine product not basing on the weight of batteries.

### Solution to Problem

A determination method of a battery for determining whether a battery is genuine or not, the method comprising: a specifying step of specifying, as a state of the battery, a state X defined by a state of charge (SOC) or a voltage; a first adjusting step of adjusting a state of the battery to a state Y by performing at least one of charge and discharge to the battery in the state X; a first measuring step of measuring a resistance value of the battery in the state Y adjusted in the first adjusting step, the resistance value regarded as a first resistance value; a second adjusting step of adjusting a state of the battery to the state Y again by performing charge and discharge to the battery after the first measuring step, the charge and the discharge correspond to below (i) or (ii): (i) when the battery is adjusted to the state Y from a high SOC side or a high voltage side in the first adjusting step, the charge and the discharge are performed in the order of discharge and charge so as to adjust the state to the state Y again from a low SOC side or a low voltage side; (ii) when the battery is adjusted to the state Y from a low SOC side or a low voltage side in the first adjusting step, the charge and the discharge are performed in the order of charge and discharge so as to adjust the state to the state Y again from a high SOC side or a high voltage side; a second measuring step of measuring a resistance value of the battery in the state Y adjusted in the second adjusting step, the resistance value regarded as a second resistance value; and a determining step of determining whether the battery is genuine or not based on the first resistance value and the second resistance value.

The invention is set out in the appended set of claims.

### Advantageous Effects of Disclosure

The present disclosure exhibits an effect of determining a non-genuine product not basing on the weight of batteries.

### Brief Description of Drawings

FIG. 1 is a flow chart exemplifying the determination method of a battery in the present disclosure.
FIGS. 2A and 2B are drawings explaining the mechanism in the present disclosure.
FIGS. 3A and 3B are drawings explaining an example of the first adjusting step in the present disclosure.
FIGS. 4A and 4B are drawings explaining an example of the first adjusting step in the present disclosure.
FIGS. 5A and 5B are drawings explaining an example of the first adjusting step in the present disclosure.
FIGS. 6A and 6B are drawings explaining the second adjusting step in the present disclosure.
FIG. 7 is a drawing exemplifying the determination in the determining step in the present disclosure.

### Description of Embodiments

The determination method of a battery in the present disclosure will be hereinafter explained in details.

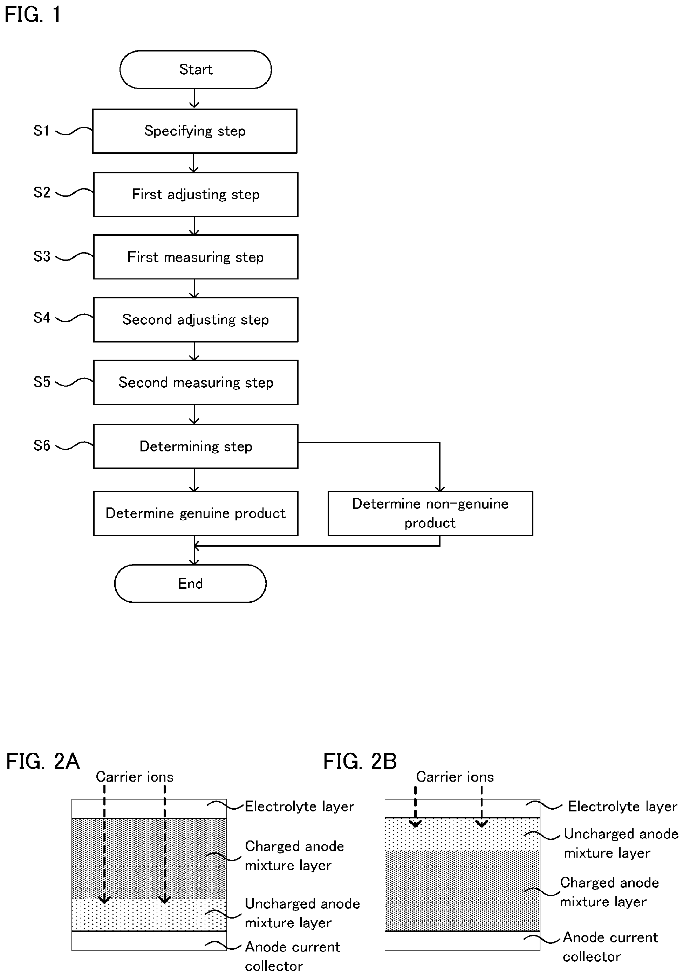

FIG. 1 is a flow chart exemplifying the determination method of a battery in the present disclosure. In the determination method of a battery in the present disclosure, first, as a state of the battery, a state X defined by a state of charge (SOC) or a voltage is specified (specifying step; S1). Next, a state of the battery is adjusted to a state Y by performing at least one of charge and discharge to the battery in the state X (first adjusting step; S2). Next, a resistance value of the battery in the state Y adjusted in the first adjusting step is measured as a first resistance value (first measuring step; S3). Next, a state of the battery is adjusted to the state Y again by performing charge and discharge to the battery after the first measuring step, the charge and the discharge correspond to below (i) or (ii) (second adjusting step; S4): (i) when the battery is adjusted to the state Y from a high SOC side or a high voltage side in the first adjusting step, the charge and the discharge are performed in the order of discharge and charge so as to adjust the state to the state Y again from a low SOC side or a low voltage side; (ii) when the battery is adjusted to the state Y from a low SOC side or a low voltage side in the first adjusting step, the charge and the discharge are performed in the order of charge and discharge so as to adjust the state to the state Y again from a high SOC side or a high voltage side. Next, a resistance value of the battery in the state Y adjusted in the second adjusting step is measured as a second resistance value (second measuring step; S5). Then, whether the battery is genuine or not is determined based on the first resistance value and the second resistance value (determining step; S6).

According to the present disclosure, whether the battery is genuine or non-genuine product is determined based on the resistance value (resistance value after discharge) after adjusting the battery to the state Y from the high SOC side or the high voltage side, and based on the resistance value (resistance value after charge) after adjusting the battery to the state Y from the low SOC side or the low voltage side, and thus the non-genuine product can be determined not basing on the weight of batteries.

The mechanism of the determination method in the present disclosure will be explained with reference to drawings. FIGS. 2A and 2B are drawings explaining the mechanism in the present disclosure. In specific, FIG. 2A is a drawing showing the movement of ions (carrier ions) when the battery is charged until the specified state of charge (SOC) and then further charged, and FIG. 2B is a drawing showing the movement of ions (carrier ions) when the battery is discharged until the specified SOC and then charged. As shown in FIG. 2A, when the battery is charged, the charge reaction proceeds from the anode mixture layer (anode active material) in the electrolyte layer side. For this reason, when the battery is charged until the specified SOC and then further charged, the carrier ions need to react with the anode active material in the anode current collector side, which means the movement distance of the carrier ions become longer. As a result, the charge resistance becomes relatively large. Also, as shown in FIG. 2B, when the battery is discharged, the discharge reaction proceeds from the anode mixture layer (anode active material) in the electrolyte layer side. For this reason, when the battery is discharged until the specified SOC and then charged, the carrier ions can react with the anode active material in the electrolyte layer side, and thus the movement distance of the carrier ions is short, and the charge resistance becomes relatively small. Incidentally, when the battery is charged until the specified SOC and then discharged, the discharge resistance becomes relatively small, and when the battery is discharged until the specified SOC and then further discharged, the discharge resistance becomes relatively large.

In this manner, in the charge and the discharge of a battery, active materials positioned in the electrolyte layer side are used in the charge and discharge reactions on a priority basis, and thus there may be unevenness in concentration of the carrier ions in the electrolyte layer (cathode mixture layer and anode mixture layer). Also, as shown in FIGS. 2A and 2B, due to the difference in history of the battery, that is, difference of whether the battery is charged or discharged right before, the resistances (charge resistances and discharge resistances) of batteries are different even though the batteries are adjusted to the same SOC. Also, such a difference in the resistance due to the unevenness of the ion concentration is influenced by factors such as the materials of the anode mixture layer and the cathode mixture layer, the thickness and the capacity ratio. For this reason, by comparing the difference in the resistance with that of a battery of the genuine product, whether the targeted battery is a genuine product or a non-genuine product can be determined.

### 1. Specifying step

The specifying step in the present disclosure is a step of specifying, as a state of the battery, a state X defined by a state of charge (SOC) or a voltage. There are no particular limitations on the method for specifying the state X, and examples thereof may include a method using devices such as an ammeter and a voltmeter.

Based on the specified result, by what kind of charge and discharge control, the battery is to be adjusted to the state Y in the later described first adjusting step, can be determined. For example, when the SOC or the voltage in the state X is lower than those of the state Y, it can be determined that the battery is to be charged to adjust to the state Y in the first adjusting step. Also, when the SOC or the voltage is lower than those of the state Y, it can be determined that the battery is to be charged and then discharged to adjust to the state Y in the first adjusting step. Also, for example, when the SOC or the voltage of the state X is higher than those of the state Y, it can be determined that the battery is to be discharged to adjust to the state Y in the first adjusting step. Also, when the SOC or the voltage is higher than those of the state Y, it can be determined that the battery is to be discharged and then charged to adjust to the state Y in the first adjusting step.

### 2. First adjusting step

The first adjusting step in the present disclosure is a step of adjusting a state of the battery to a state Y by performing at least one of charge and discharge to the battery in the state X. When the above described state X is in a state defined by the SOC, the state Y is also in a state defined by the SOC. Similarly, when the above described state X is in a state defined by the voltage, the state Y is also in a state defined by the voltage.

When the state Y is a state Y (SOC) defined by the state of charge (SOC) of the battery, the state Y (SOC) is usually less than 100%. The state Y (SOC) is, for example, 20% or more, may be 30% or more, and may be 50% or more. Meanwhile, the state Y (SOC) is, for example, 90% or less, and may be 70% or less.

Meanwhile, when the state Y is a state Y (voltage) defined by the voltage of the battery, there are no particular limitations on the state Y (voltage). Here, when V_{Y} designates the state Y (voltage), and V_{M} designates the voltage of the battery when fully charged, the V_{Y} is usually less than V_{M}. V_{Y}/V_{M} is, for example, 0.2 or more, may be 0.3 or more, and may be 0.5 or more. Meanwhile, V_{Y}/V_{M} is, for example, 0.9 or less, and may be 0.7 or less.

The state Y may be arranged in advance, and may be arranged based on the state X specified in the specifying step. For example, when the state X is in the same state as the state Y arranged in advance (for example, when the SOC of the state X is the same as that of the state Y), the state Y may be arranged in a state of SOC different from that of the state X.

The current values of the charge and the discharge in the first adjusting step are respectively, for example, 1/5 C or more, may be 1/4 C or more, and may be 1/3 C or more. Meanwhile, the current values in the charge and the discharge are respectively, for example, 1 C or less, and may be 2/3 C or less.

Here, the charge and the discharge in the first adjusting step when the state of the battery is defined by SOC will be explained.

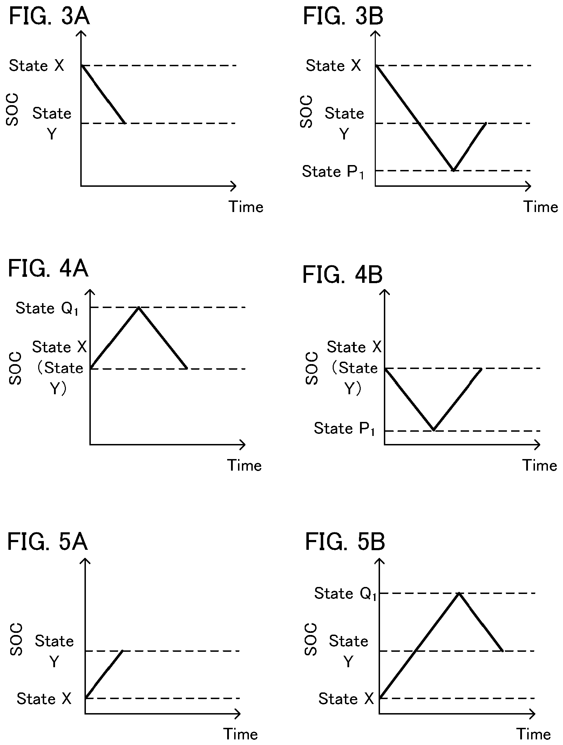

FIGS. 3A and 3B are drawings explaining an example of the first adjusting step in the present disclosure. In specific, FIG. 3A is a drawing explaining the first adjusting step when the SOC of the state X is higher than that of the state Y, and when the first resistance value is measured as the resistance value after discharge. Also, FIG. 3B is a drawing explaining the first adjusting step when the SOC of the state X is higher than that of the state Y, and when the first resistance value is measured as the resistance value after charge. For example, as shown in FIG. 3A, the battery may be adjusted to the state Y by just performing discharge. Thereby, the later described first resistance value can be measured as the resistance value after discharge. Meanwhile, as shown in FIG. 3B, the battery may be adjusted to the state Y by performing both discharge and charge. For example, from the state X, the battery is discharged until a state P₁ that is a state with lower SOC than that of the state Y, and then charged from the state P₁ until the state Y. Thereby, the later described first resistance value can be measured as the resistance value after charge. Incidentally, for example, the state P₁ is preferably in a condition of which SOC is lower in 5% or more compared to that of the state Y.

FIGS. 4A and 4B are drawings explaining an example of the first adjusting step in the present disclosure. In specific, FIG. 4A is a drawing explaining the first adjusting step when the SOC of the state X is the same as that of the state Y, and when the first resistance value is measured as the resistance value after discharge. Also, FIG. 4B is a drawing explaining the first adjusting step when the SOC of the state X is the same as that of the state Y, and when the first resistance value is measured as the resistance value after charge. When the SOC of the state X is the same as that of the state Y, as shown in FIGS. 4A and 4B, in the first adjusting step, it is preferable to adjust the battery to the state Y by performing both charge and discharge. For example, as shown in FIG. 4A, for example, the battery is charged until a state Q₁ of which SOC is higher than that of the state X (state Y), and then discharged from the state Q₁ until the state Y. Thereby, the later described first resistance value can be measured as the resistance value after discharge. Incidentally, the state Q₁ is, for example, preferably in a condition of which SOC is higher in 5% or more compared to that of the state Y. Meanwhile, as shown in FIG. 4B, for example, the battery is discharged until a state P₁ of which SOC is lower than that of the state X (state Y), and then charged from the state P₁ until the state Y. Thereby, the later described first resistance value can be measured as the resistance value after charge. The state P₁ is as described above.

FIGS. 5A and 5B are drawings explaining an example of the first adjusting step in the present disclosure. In specific, FIG. 5A is a drawing explaining the first adjusting step when the SOC of the state X is lower than that of the state Y, and when the first resistance value is measured as the resistance value after charge. Also, FIG. 5B is a drawing explaining the first adjusting step when the SOC of the state X is lower than that of the state Y, and when the first resistance value is measured as the resistance value after discharge. As shown in FIG. 5A, the battery may be adjusted to the state Y by performing just charge. Thereby, the later described first resistance value can be measured as the resistance value after charge. Meanwhile, as shown in FIG. 5B, the battery may be adjusted to the state Y by performing both discharge and charge. For example, from the state X, the battery is charged until a state Q₁ of which SOC is higher than that of the state Y, and then discharged from the state Q₁ until the state Y. Thereby, the later described first resistance value can be measured as the resistance value after discharge. Incidentally, the state Q₁ is as described above.

### 3. First measuring step

The first measuring step in the present disclosure is a step of measuring a resistance value of the battery in the state Y adjusted in the first adjusting step, as a first resistance value. The first resistance value may be a charge resistance value and may be a discharge resistance value. There are no particular limitations on the method for measuring the first resistance value, and examples thereof may include an I-V method.

### 4. Second adjusting step

The second adjusting step in the present disclosure is a step of adjusting a state of the battery to the state Y again by performing charge and discharge to the battery after the first measuring step, the charge and the discharge correspond to below (i) or (ii):
(i) when the battery is adjusted to the state Y from a high SOC side or a high voltage side in the first adjusting step, the charge and the discharge are performed in the order of discharge and charge so as to adjust the state to the state Y again from a low SOC side or a low voltage side;
(ii) when the battery is adjusted to the state Y from a low SOC side or a low voltage side in the first adjusting step, the charge and the discharge are performed in the order of charge and discharge so as to adjust the state to the state Y again from a high SOC side or a high voltage side.

Here, the charge and the discharge in the second adjusting step when the state of the battery is defined by the SOC will be explained. Incidentally, when the first resistance value is the charge resistance, the state (such as SOC) of the battery after the first measuring step is considered to be higher than that of the state Y, but the difference from the state Y is considered to be extremely small. Also, when the first resistance value is the discharge resistance, the state (such as SOC) of the battery after the first measuring step is considered to be lower than that of the state Y, but the difference from the state Y is considered to be extremely small. Thus, in the present disclosure, the state of the battery after the first measuring step can be taken as substantially the same as that of the state Y.

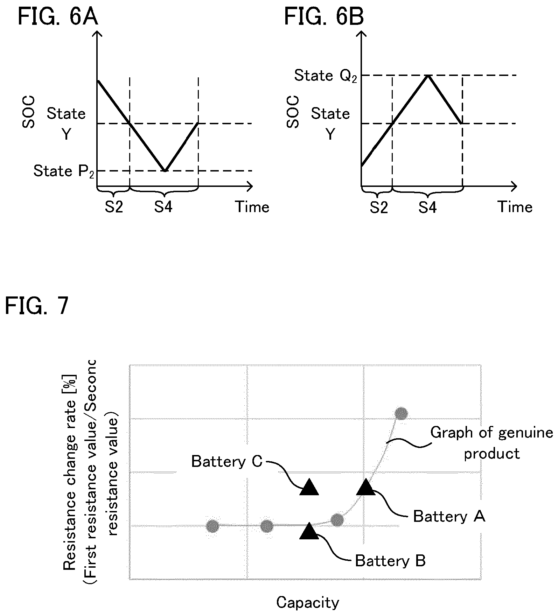

FIGS. 6A and 6B are drawings explaining the second adjusting step in the present disclosure. In specific, FIG. 6A is a drawing explaining charge and discharge in the second adjusting step corresponding to the (i). Also, FIG. 6B is a drawing explaining charge and discharge in the second adjusting step corresponding to the (ii). For example, as shown in FIG. 6A, when the battery is adjusted to the state Y from the high SOC side in the first adjusting step S2, in the second adjusting step S4, the battery is discharged until a state P₂ of which SOC is lower than that of the state Y, and then charged from the state P₂ until the state Y. Thereby, the later described second resistance value can be measured as a resistance value after charge. Incidentally, the state P₂ is, for example, preferably in a condition of which SOC is lower in 5% or more compared to that of the state Y. Also, the state P₂ may be the same as or different from the above described state P₁.

Meanwhile, for example, as shown in FIG. 6B, in the first adjusting step S2, when the battery is adjusted to the state Y from the low SOC side, in the second adjusting step S4, the battery is charged until a state Q₂ of which SOC is higher than that of the state Y, and then discharged from the state Q₂ until the state Y. Thereby, the later described second resistance value can be measured as the resistance value after discharge. Incidentally, the state Q₂ is, for example, preferably in a condition of which SOC is higher in 5% or more compared to that of the state Y. Also, the state Q₂ may be the same as or different from the state Q₁ described above.

The current values of the charge and the discharge in the second adjusting step are respectively, for example, 1/5 C or more, may be 1/4 C or more, and may be 1/3 C or more. Meanwhile, the current values in the charge and the discharge are respectively, for example, 1 C or less, and may be 2/3 C or less. Also, the current values of the charge and the discharge in the second adjusting step may be respectively same as or different from the current values of the charge and the discharge in the first adjusting step.

### 5. Second measuring step

The second measuring step in the present disclosure is a step of measuring a resistance value of the battery in the state Y adjusted in the second adjusting step, a second resistance value. When the first resistance value is a charge resistance value, the second resistance value is preferably also a charge resistance value. Similarly, when the first resistance value is a discharge resistance value, the second resistance value is preferably also a discharge resistance. There are not particular limitations on the method for measuring the second resistance value, and examples thereof may include an I-V method.

### 6. Determining step

The determining step in the present disclosure is a step of determining whether the battery is genuine or not based on the first resistance value and the second resistance value.

In the determining step, whether the battery is genuine or not is determined by an arbitrary method using the first resistance value and the second resistance value. For example, when R1 designates the first resistance value and R2 designates the second resistance value, it can be determined based on the absolute value of the difference between R1 and R2 (|R1-R2| : Resistance change amount), or the ratio of the first resistance value R1 with respect to the second resistance value R2 (R1/R2 : Resistance change rate). For example, as shown in FIG. 7, regarding the battery of the genuine product in each capacity (such as capacity per unit area), the resistance change rate is calculated with the specified condition Y (such as SOC 50%), and a graph of the resistance change rate with respect to the capacity is created. Next, the resistance change rate calculated with respect to the targeted battery with the specified capacity is compared with the graph. Then, the resistance change rate of the genuine product with the specified capacity is compared with that of the targeted battery, and when the absolute value of the difference between the two is the reference value or less, it can be determined that the targeted battery is a genuine product, and when the absolute value of the difference between the two exceeds the reference value, it can be determined that the targeted battery is a non-genuine product. For example, in FIG. 7, the battery A and the battery B can be determined as a genuine product, and the battery C can be determined as a non-genuine product.

The reference value can be appropriately adjusted based on factors such as the kind of the battery and the capacity of the battery. For example, when T designates the resistance change rate and the resistance change amount of a genuine product, the reference value is, for example, 0.01 T or more and 0.1 T or less.

### 7. Battery

The battery targeted to the determination in the present disclosure may be a liquid-based battery of which electrolyte is a liquid-based electrolyte, and may be an all solid state battery of which electrolyte is a solid electrolyte. Also, the battery may be, for example, a battery using positive ions as the carrier ions such as a lithium ion battery and a sodium ion battery, and may be a battery using negative ions as the carrier ions such as a fluoride ion battery.

Also, the capacity per unit area (mAh/cm²) of the battery in the present disclosure is preferably large. When the capacity per unit area is large, the thickness of the electrolyte layer increases, and thus the unevenness of the ion concentration easily occurs due to charge and discharge, and the resistance change amount (|R1-R2| or R1/R2) increases. As a result, determination of the genuine product and the non-genuine product can be more easily performed. The capacity per unit area (mAh/cm²) of the battery is, for example, 1 mAh/cm² or more.

## Claims

1. A determination method of a battery for determining whether a battery is genuine or not, wherein a genuine battery is a battery produced by a regular manufacturer, as opposed to a non-genuine product such as a battery imitating the genuine product, the method **characterized by** comprising:
a specifying step (S1) of specifying, as a state of the battery, a state X defined by a state of charge (SOC) or a voltage;
a first adjusting step (S2) of adjusting a state of the battery to a state Y by performing at least one of charge and discharge to the battery in the state X;
a first measuring step (S3) of measuring a resistance value of the battery in the state Y adjusted in the first adjusting step, the resistance value regarded as a first resistance value;
a second adjusting step (S4) of adjusting a state of the battery to the state Y again by performing charge and discharge to the battery after the first measuring step, the charge and the discharge correspond to below (i) or (ii):
(i) when the battery is adjusted to the state Y from a high SOC side or a high voltage side in the first adjusting step, the charge and the discharge are performed in the order of discharge and charge so as to adjust the state to the state Y again from a low SOC side or a low voltage side;
(ii) when the battery is adjusted to the state Y from a low SOC side or a low voltage side in the first adjusting step, the charge and the discharge are performed in the order of charge and discharge so as to adjust the state to the state Y again from a high SOC side or a high voltage side;
a second measuring step (S5) of measuring a resistance value of the battery in the state Y adjusted in the second adjusting step, the resistance value regarded as a second resistance value; and
a determining step (S6) of determining whether the battery is genuine or not based on the first resistance value and the second resistance value.

2. The determination method according to claim 1, **characterized in that** the state X and the state Y are defined by the state of charge (SOC).

3. The determination method according to claim 1, **characterized in that** the state X and the state Y are defined by the voltage.

4. The determination method according to any one of claims 1 to 3, characterize in that at least one of the charge and the discharge are performed at a current value of 1/3 C or more in the first adjusting step.

5. The determination method according to any one of claims 1 to 3, **characterized in that** the charge and the discharge are performed at a current value of 1/3 C or more in the second adjusting step.

6. The determination method according to any one of claims 1 to 3, **characterized in that** the charge and the discharge corresponding to the (i) are performed in the second adjusting step.

7. The determination method according to any one of claims 1 to 3, **characterized in that** the charge and the discharge corresponding to the (ii) are performed in the second adjusting step.

## Patentansprüche

1. Bestimmungsverfahren einer Batterie zum Bestimmen, ob eine Batterie unverfälscht ist oder nicht, wobei eine unverfälschte Batterie eine von einem regulären Hersteller hergestellte Batterie ist, im Gegensatz zu einem verfälschten Produkt, wie einer Batterie, die das unverfälschte Produkt nachahmt, wobei das Verfahren **dadurch gekennzeichnet ist, dass** es umfasst:
einen Spezifizierungsschritt (S1) des Spezifizierens eines Zustands X als einen Zustand der Batterie, wobei der Zustand X durch einen Ladezustand (SOC) oder eine Spannung definiert ist;
einen ersten Anpassungsschritt (S2) des Anpassens eines Zustands der Batterie auf einen Zustand Y durch Durchführen wenigstens einer Ladung und einer Enladung an der Batterie in dem Zustand X;
einen ersten Messschritt (S3) des Messens eines Widerstandswerts der Batterie in dem Zustand Y, der in dem ersten Anpassungsschritt angepasst wird, wobei der Widerstandswert als ein erster Widerstandswert betrachtet wird;
einen zweiten Anpassungsschritt (S4) des erneuten Anpassens eines Zustands der Batterie an den Zustand Y durch Durchführen einer Ladung und Entladung an der Batterie nach dem ersten Messschritt, wobei die Ladung und die Entladung (i) oder (ii) nachstehend entsprechen:
(i) wenn die Batterie in dem ersten Anpassungsschritt von einer Seite mit hohem SOC oder einer Seite mit hoher Spannung auf den Zustand Y angepasst wird, die Ladung und Entladung in der Reihenfolge Entladung und Ladung durchgeführt werden, um den Zustand erneut von einer Seite mit niedrigem SOC oder einer Seite mit niedriger Spannung auf den Zustand Y anzupassen;
(ii) wenn die Batterie in dem ersten Anpassungsschritt von einer Seite mit niedrigem SOC oder einer Seite mit niedriger Spannung auf den Zustand Y angepasst wird, die Ladung und Entladung in der Reihenfolge Ladung und Entladung durchgeführt werden, um den Zustand erneut von einer Seite mit hohem SOC oder einer Seite mit hoher Spannung auf den Zustand Y anzupassen;
einen zweiten Messschritt (S5) des Messens eines Widerstandswerts der Batterie in dem Zustand Y, der in dem zweiten Anpassungsschritt angepasst wird, wobei der Widerstandswert als ein zweiter Widerstandswert betrachtet wird; und
einen Bestimmungsschritt (S6) des Bestimmens, ob die Batterie unverfälscht ist oder nicht, auf Grundlage des ersten Widerstandswerts und des zweiten Widerstandswerts.

2. Bestimmungsverfahren nach Anspruch 1, **dadurch gekennzeichnet, dass** der Zustand X und der Zustand Y durch den Ladezustand (SOC) bestimmt werden.

3. Bestimmungsverfahren nach Anspruch 1, **dadurch gekennzeichnet, dass** der Zustand X und der Zustand Y durch die Spannung bestimmt werden.

4. Bestimmungsverfahren nach einem der Ansprüche 1 bis 3, **dadurch gekennzeichnet, dass** wenigstens eines der Ladung und der Entladung in dem ersten Anpassungsschritt mit einem Stromwert von 1/3 C oder mehr durchgeführt werden.

5. Bestimmungsverfahren nach einem der Ansprüche 1 bis 3, **dadurch gekennzeichnet, dass** die Ladung und die Entladung in dem zweiten Anpassungsschritt mit einem Stromwert von 1/3 C oder mehr durchgeführt werden.

6. Bestimmungsverfahren nach einem der Ansprüche 1 bis 3, **dadurch gekennzeichnet, dass** die Ladung und die Entladung, die (i) entsprechen, in dem zweiten Anpassungsschritt durchgeführt werden.

7. Bestimmungsverfahren nach einem der Ansprüche 1 bis 3, **dadurch gekennzeichnet, dass** die Ladung und die Entladung, die (ii) entsprechen, in dem zweiten Anpassungsschritt durchgeführt werden.

## Revendications

1. Procédé de détermination d'une batterie pour déterminer si une batterie est d'origine ou non, une batterie d'origine étant une batterie produite par un fabricant agréé, par opposition à un produit non d'origine tel qu'une batterie imitant le produit d'origine,
le procédé étant **caractérisé en ce qu'**il comprend :
une étape de spécification (S1) consistant à spécifier, en tant qu'état de la batterie, un état X défini par un état de charge (SOC, state of charge) ou une tension,
une première étape de réglage (S2) consistant à régler l'état de la batterie à un état Y en réalisant une charge et/ou une décharge de la batterie à l'état X,
une première étape de mesure (S3) consistant à mesurer une valeur de résistance de la batterie à l'état Y réglé lors de la première étape de réglage, la valeur de résistance représentant une première valeur de résistance,
une deuxième étape de réglage (S4) consistant à régler à nouveau l'état de la batterie à l'état Y en réalisant une charge et une décharge de la batterie après la première étape de mesure, la charge et la décharge correspondant à (i) ou (ii) ci-dessous :
(i) lorsque la batterie est réglée à l'état Y à partir d'un côté SOC élevé ou d'un côté tension élevée lors de la première étape de réglage, la charge et la décharge sont réalisées dans l'ordre décharge puis charge de façon à ramener l'état audit état Y à partir d'un côté SOC faible ou d'un côté tension faible,
(ii) lorsque la batterie est réglée à l'état Y à partir d'un côté SOC faible ou d'un côté tension faible lors de la première étape de réglage, la charge et la décharge sont réalisées dans l'ordre charge puis décharge de façon à ramener l'état audit état Y à partir d'un côté SOC élevé ou d'un côté tension élevée,
une deuxième étape de mesure (S5) consistant à mesurer la valeur de résistance de la batterie à l'état Y réglé lors de la deuxième étape de réglage, la valeur de résistance représentant une deuxième valeur de résistance, et
une étape de détermination (S6) consistant à déterminer si la batterie est d'origine ou non en fonction de la première valeur de résistance et de la deuxième valeur de résistance.

2. Procédé de détermination selon la revendication 1, **caractérisé en ce que** l'état X et l'état Y sont définis par l'état de charge (SOC, state of charge).

3. Procédé de détermination selon la revendication 1, **caractérisé en ce que** l'état X et l'état Y sont définis par la tension.

4. Procédé de détermination selon l'une quelconque des revendications 1 à 3, **caractérisé en ce que** la charge et/ou la décharge sont réalisées à une valeur de courant supérieure ou égale à 1/3 C au cours de la première étape de réglage.

5. Procédé de détermination selon l'une quelconque des revendications 1 à 3, **caractérisé en ce que** la charge et la décharge sont réalisées à une valeur de courant supérieure ou égale à 1/3 C au cours de la deuxième étape de réglage.

6. Procédé de détermination selon l'une quelconque des revendications 1 à 3, **caractérisé en ce que** la charge et la décharge correspondant à (i) sont réalisées au cours de la deuxième étape de réglage.

7. Procédé de détermination selon l'une quelconque des revendications 1 à 3, **caractérisé en ce que** la charge et la décharge correspondant à (ii) sont réalisées au cours de la deuxième étape de réglage.
